# EUROPEAN PATENT APPLICATION

(11) **EP 3 165 633 A1**
(43) Date of publication of application: **10.05.2017**
(21) Application number: 16196501.7
(22) Date of filing: 31.10.2016
(51) Int. Cl.: C23C 16/24, C23C 16/30, C23C 16/40, C23C 16/56

(54) **THERMAL CHEMICAL VAPOR DEPOSITION SPLIT-FUNCTIONALIZATION PROCESS, PRODUCT AND COATING**

(30) Priority: 05.11.2015 US 201514933295
(71) Applicant: Silcotek Corp., Bellefonte, Pennsylvania 16823 (US)
(72) Inventor: YUAN, Min, State College, PA 16803 (US); SMITH, David A., Bellefonte, PA 16823 (US); SILVIS, Paul H., Port Matilda, PA 16870 (US); MATTZELA, James B., Port Matilda, PA 16870 (US)
(74) Representative: Loock, Jan Pieter

(57) **Abstract**

Thermal chemical vapor deposition split-functionalizing processes, coatings, and products are disclosed. The thermal chemical vapor deposition split-functionalizing process includes positioning an article within an enclosed chamber, functionalizing the article within a first temperature range for a first period of time, and then further functionalizing the article within a second temperature range for a second period of time. The thermal chemical vapor deposition split-functionalized product includes a functionalization formed by functionalizing within a first temperature range for a first period of time and a further functionalization formed by further functionalizing within a second temperature range for a second period of time.

## Description

### FIELD OF THE INVENTION

The present invention is directed to thermal chemical vapor deposition processes and products produced from such processes. More particularly, the present invention is directed to such processes and products with multiple functionalizations.

### BACKGROUND OF THE INVENTION

Often, surfaces of substrates do not include desired performance characteristics. The failure to include specific desired performance characteristics can result in surface degradation in certain environments, an inability to meet certain performance requirements, or combinations thereof. For example, in certain environments, substrate surfaces can be subjected to wear and other undesirable surface activities such as chemical adsorption, catalytic activity, oxidation, byproduct accumulation or stiction, and/or other undesirable surface activities.

Undesirable surface activities can cause chemisorption of other molecules, reversible and irreversible physisorption of other molecules, catalytic reactivity with other molecules, attack from foreign species, a molecular breakdown of the surface, physical loss of substrate, or combinations thereof.

Surfaces on sample containers, such as within sample cylinders, can interact with gaseous samples stored or collected within such sample containers. For example, when gaseous samples containing hydrogen sulfide, methyl mercaptan, and carbonyl sulfide are stored within sample containers having certain interior coatings for a period of time, the amount of methyl mercaptan recoverable is substantially lower than the original amount.

Thermal chemical vapor deposition split-functionalization processes, coatings, and products that show one or more improvements in comparison to the prior art would be desirable in the art.

### BRIEF DESCRIPTION OF THE INVENTION

In an embodiment, a thermal chemical vapor deposition split-functionalizing process includes positioning an article within an enclosed chamber, functionalizing the article within a first temperature range for a first period of time, and then further functionalizing the article within a second temperature range for a second period of time.

In another embodiment, a thermal chemical vapor deposition split-functionalizing process includes positioning an article within an enclosed chamber, exposing the article to dimethylsilane at conditions above the decomposition conditions for the dimethylsilane to produce a surface, oxidizing the article within the enclosed chamber to produce an oxidized surface, functionalizing within a first temperature range for a first period of time exposing the oxidized surface to trimethylsilane, and then further functionalizing within a second temperature range for a second period of time. The first temperature range and the second temperature range are within a range of 400°C and 500°C.

In another embodiment, a thermal chemical vapor deposition split-functionalized product includes a functionalization formed by functionalizing within a first temperature range for a first period of time and a further functionalization formed by further functionalizing within a second temperature range for a second period of time.

Other features and advantages of the present invention will be apparent from the following more detailed description, which illustrates, by way of example, the principles of the invention.

### DETAILED DESCRIPTION OF THE INVENTION

Provided are a thermal chemical vapor deposition (CVD) split-functionalization process, coatings, and products. Embodiments of the present disclosure, for example, in comparison to concepts failing to include one or more of the features disclosed herein, permit increased resistance to surface degradation in certain environments, permit decreased wear and other undesirable surface activities (for example, chemical adsorption, catalytic activity, oxidation, byproduct accumulation, and/or stiction), permit reduced or eliminated catalytic reactivity with other molecules, permit reduced or eliminated attack from foreign species, permit reduced or eliminated molecular breakdown, permit reduced or eliminated physical loss of substrate, permit higher methyl mercaptan recovery, permit coating without aid of non-thermal techniques (such as, plasma, radiofrequency, catalysts, radiation)or a combination thereof.

A thermal CVD product includes a substrate and a split-functionalized surface, for example, of the substrate or a coating. As used herein, the phrase "thermal CVD" refers to thermal application that does not encompass plasma-assisted techniques. The thermal CVD product is any suitable article capable of being coated through thermal CVD. The split-functionalized surface includes a functionalization formed by functionalizing within a first temperature range for a first period of time and a further functionalization formed by further functionalizing within a second temperature range for a second period of time. As used herein, the term "functionalized" and grammatical variations thereof refer to bonding of a terminated group with the surface.

Suitable articles for producing the thermal CVD split-functionalized product include, but are not limited to, tubes (for example, interior and/or exterior surfaces), planar geometry structures, non-planar geometry structures, complex geometry structures, metallic structures, metal structures, and/or ceramic structures.

Such structures are capable of being forged structures, molded structures, additively-produced structures, or any other suitable structure. In one embodiment, the surface is or includes a stainless steel surface (martensitic or austenitic), a nickel-based alloy, a metal surface, a metallic surface (ferrous or non-ferrous; tempered or non-tempered; and/or equiaxed, directionally-solidified, or single crystal), a ceramic surface, a ceramic matrix composite surface, a glass surface, ceramic matrix composite surface, a composite metal surface, a coated surface, a fiber surface, a foil surface, a film, a polymeric surface (such as, polyether etherketone), and/or any other suitable surface capable of withstanding operational conditions of the thermal CVD process.

In another embodiment, the surface is formed from a silane-based material, for example, formed from dimethylsilane (for example, in gaseous form), trimethylsilane, dialkylsilyl dihydride, alkylsilyl trihydride, non-pyrophoric species (for example, dialkylsilyl dihydride and/or alkylsilyl trihydride), thermally reacted material (for example, carbosilane and/or carboxysilane, such as, amorphous carbosilane and/or amorphous carboxysilane), species capable of a recombination of carbosilyl (disilyl or trisilyl fragments), and/or any other suitable silane-based material. Such materials may be applied iteratively and/or with purges in between, for example, with an inert gas (such as, nitrogen, helium, and/or argon, as a partial pressure dilutant). The thickness of such materials is between 100 nm and 10,000 nm, between 100 nm and 5,000 nm, between 200 nm and 5,000 nm, between 100 nm and 3,000 nm, between 300 nm and 1,500 nm, or any combination, sub-combination, range, or sub-range thereof.

Additionally, in further embodiments, the surface is treated. Suitable treatments include, but are not limited to, exposure to water (alone, with zero air, or with an inert gas), oxygen (for example, at a concentration, by weight, of at least 50%), air (for example, alone, not alone, and/or as zero air), nitrous oxide, ozone, peroxide, or a combination thereof. As used herein, the term "zero air" refers to atmospheric air having less than 0.1 ppm total hydrocarbons. The term "air" generally refers to a gaseous fluid, by weight, of mostly nitrogen, with the oxygen being the second highest concentration species within. For example, in one embodiment, the nitrogen is present at a concentration, by weight, of at least 70% (for example, between 75% and 76%) and oxygen is present at a concentration, by weight, of at least 20% (for example, between 23% and 24%).

According to the disclosure, the split-functionalization includes iteratively modifying a surface by thermally reacting a gas in one or both of an enclosed chamber(s) and/or a vessel(s) to form a thermal CVD split-functionalization on the surface. Use of the term "enclosed" is intended to encompass static CVD techniques and differentiate from constant flow CVD techniques. The gas is selected from the group consisting of trimethylsilane, methyltrimethoxysilane, methyltriethoxysilane, dimethyldimethoxysilane, dimethyldiethoxysilane, trimethylmethoxysilane, trimethylethoxysilane, any other species of gas capable of functionalizing under the conditions disclosed herein, and combinations thereof.

In one embodiment, the split-functionalizing includes introducing a suitable organosilane reagent. One suitable organosilane reagent is a trifunctional organosilane that consists of the general formula RR'R"Si-H, where R, R', R" are organofunctional groups. Examples of the organofunctional groups are alkyl, aryl, halogenated alkyl and aryl, ketones, aldehydes, acyl, alcohol, epoxy, and nitro - organo groups, and organometallic functionalities. In one embodiment, the organosilane is trimethylsilane.

The thermal CVD split-functionalization process is within one or more temperature ranges to thermally react the gas, with the ranges for the functionalization and the further functionalization being identical, overlapping, or different ranges. Suitable temperature ranges include, but are not limited to, between 100°C and 700°C, between 100°C and 450°C, between 100°C and 300°C, between 200°C and 500°C, between 300°C and 600°C, between 450°C and 700°C, 700°C, 450°C, 100°C, between 200°C and 600°C, between 300°C and 600°C, between 400°C and 500°C, 300°C, 400°C, 500°C, 600°C, or any suitable combination, sub-combination, range, or sub-range thereof.

The thermal CVD split-functionalization process is within one or more pressure ranges facilitating the thermal reaction of the gas, with the ranges for the functionalization and the further functionalization being identical, overlapping, or different ranges. Suitable pressures ranges include, but are not limited to, between 0.01 psia and 200 psia, between 1.0 psia and 100 psia, between 5 psia and 40 psia, between 20 psia and 25 psia, greater than 25 psia, greater than 20 psia, less than 20 psia, less than 15 psia, 1.0 psia, 5 psia, 20 psia, 23 psia, 25 psia, 40 psia, 100 psia, 200 psia, or any suitable combination, sub-combination, range, or sub-range therein.

Suitable dimensions for the enclosed chamber and/or vessel used in the thermal CVD process include, but are not limited to, having a minimum width of greater than 5 cm, of greater than 10 cm, greater than 20 cm, greater than 30 cm, greater than 100 cm, greater than 300 cm, greater than 1,000 cm, between 10 cm and 100 cm, between 100 cm and 300 cm, between 100 cm and 1,000 cm, between 300 cm and 1,000 cm, any other minimum width capable of uniform or substantially uniform heating, or any suitable combination, sub-combination, range, or sub-range therein. Suitable volumes include, but are not limited to, at least 1,000 cm³, greater than 3,000 cm³, greater than 5,000 cm³, greater than 10,000 cm³, greater than 20,000 cm³, between 3,000 cm³ and 5,000 cm³, between 5,000 cm³ and 10,000 cm³, between 5,000 cm³ and 20,000 cm³, between 10,000 cm³ and 20,000 cm³, any other volumes capable of uniform or substantially uniform heating, or any suitable combination, sub-combination, range, or sub-range therein.

The duration of the functionalization and the further functionalization are identical, overlapping, or different ranges. In one embodiment, the duration of the first period of time (for the functionalizing) is at least 2 hours, at least 3 hours, at least 4 hours, at least 5 hours, at least 7 hours, between 4 and 10 hours, between 6 and 8 hours, or any suitable combination, sub-combination, range, or sub-range therein. Additionally or alternatively, in one embodiment, the duration of the second period of time (for the further functionalizing) is briefer than the first period of time, for example, by at least 1 hour, at least 2 hours, at least 3 hours, between 1 and 5 hours, between 1 and 4 hours, or any suitable combination, sub-combination, range, or sub-range therein.

As will be appreciated, further embodiments include subsequent functionalizations (for example, a third, a fourth, a fifth, etc.) and/or depositions (for example, a second, a third, a fourth, etc.) having durations that are greater than, the same as, or briefer than the duration of the functionalization, the further functionalization, and/or the deposition. Other suitable duration ranges for the exposing and/or maintaining include, but are not limited to, between 10 minutes and 24 hours, between 1 hours and 10 hours, between 2 hours and 10 hours, between 4 hours and 6 hours, between 4 hours and 8 hours, at least 10 minutes, at least 1 hours, at least 4 hours, at least 10 hours, less than 10 hours, less than 8 hours, less than 6 hours, less than 4 hours, or any suitable combination, sub-combination, range, or sub-range therein.

Through the thermal CVD split-functionalization process, methyl mercaptan recovery is substantially improved. In one embodiment, the increase in methyl mercaptan recovery is from a 40% recovery to an 80% recovery (over 100% improvement, specifically, a 200% improvement) under testing at an initial time, 24 hours, and 48 hours. Specifically, such increases in methyl mercaptan recovery are based upon gaseous components of hydrogen sulfide, methyl mercaptan, and carbonyl sulfide.

In further embodiments, the thermal CVD split-functionalization process includes any suitable additional steps before, after, or between the functionalizing and the further functionalizing. Suitable additional steps include, but are not limited to, cleaning, purging, pre-deposition treatment (for example, heating of the substrate and/or cold-fill), and/or oxidizing (for example, by introducing an oxidizer).

The purging of the thermal CVD process evacuates or substantially evacuates gas(es) from the enclosed chamber. In general, any portion of the thermal CVD process is capable of being preceded or followed by selectively applying a purge gas to the enclosed chamber. The purge gas is nitrogen, helium, argon, or any other suitable inert gas. The purging is in one purge cycle, two purge cycles, three purge cycles, more than three purge cycles, or any suitable number of purge cycles that permits the enclosed chamber to be a chemically inert environment.

The cleaning of the thermal CVD process removes undesirable materials from the substrate. In general, any portion of the CVD process is capable of being preceded or followed by the cleaning.

In one embodiment, the pre-deposition treatment, the functionalizing, the further functionalizing, or a combination thereof include(s) cold-fill operation. For example, in a further embodiment, the cold fill operation during the pre-deposition treatment includes introduction of the decomposition gas at a sub-decomposition temperature that is below the thermal decomposition temperature of the decomposition gas. As used herein, the phrase "sub-decomposition temperature" refers to conditions at which the decomposition gas will not appreciably thermally decompose. Depending upon the species utilized, suitable cold-fill operation temperatures include, but are not limited to, less than 30 °C, less than 60 °C, less than 100 °C, less than 150 °C, less than 200 °C, less than 250 °C, less than 300 °C, less than 350 °C, less than 400 °C, less than 440 °C, less than 450 °C, between 100 °C and 300 °C, between 125 °C and 275 °C, between 200 °C and 300 °C, between 230 °C and 270 °C, or any suitable combination, sub-combination, range, or sub-range therein.

During and/or after the introducing of the decomposition gas, the operating of the enclosed chamber includes heating to a super-decomposition temperature that is equal to or above the thermal decomposition temperature of the decomposition gas. As used herein, the phrase "super-decomposition temperature" refers to conditions at which the decomposition gas will appreciably thermally decompose. The heating of the enclosed chamber is at any suitable heating rate from the sub-decomposition temperature to the super-decomposition temperature.

The oxidizing includes exposure to any suitable chemical species capable of donating a reactive oxygen species into the coating under predetermined oxidation conditions. In general, oxidation is a bulk reaction that affects the bulk of the coating. Suitable chemical species for the oxidation include, for example, water, oxygen, air, nitrous oxide, ozone, peroxide, and combinations thereof. In one embodiment, the coating is oxidized with water as an oxidizing agent (for example, within a temperature range of 100 °C to 600 °C, a temperature range of 300 °C to 600 °C, or at a temperature of 450 °C). In one embodiment, the oxidizing is with air and water (for example, within a temperature range of 100 °C to 600 °C, a temperature range of 300 °C to 600 °C, or at a temperature of 450 °C). In one embodiment, the oxidizing is only with air (for example, within a temperature range of 100 °C to 600 °C, a temperature range of 300 °C to 600 °C, or at a temperature of 450 °C). In one embodiment, the oxidizing is with nitrous oxide (N₂O). Specifically, N₂O is applied under heat (for example, about 450 °C) with a pressure of substantially pure N₂O in a vessel with carbosilane-coated samples.

While the invention has been described with reference to one or more embodiments, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims. In addition, all numerical values identified in the detailed description shall be interpreted as though the precise and approximate values are both expressly identified.

## Claims

1. A thermal chemical vapor deposition split-functionalizing process, comprising:
positioning an article within an enclosed chamber;
functionalizing the article within a first temperature range for a first period of time; and then
further functionalizing the article within a second temperature range for a second period of time.

2. The thermal chemical vapor deposition split-functionalizing process of claim 1, wherein the first temperature range differs from the second temperature range, and the first period of time differs from the second period of time.

3. The thermal chemical vapor deposition split-functionalizing process of claim 1, wherein the first period of time is at least 4 hours and/or wherein the second period of time is at least 2 hours.

4. The thermal chemical vapor deposition split-functionalizing process of claim 1, wherein the first temperature range and the second temperature range are within a range of 400°C and 500°C.

5. The thermal chemical vapor deposition split-functionalizing process of claim 1, wherein the functionalizing is within a first pressure range and the further functionalizing is within a second pressure range, the first pressure range differing from the second pressure range or wherein the functionalizing is within a first pressure range and the further functionalizing is within a second pressure range, the first pressure range being greater than the second pressure range or wherein the functionalizing is within a first pressure range and the further functionalizing is within a second pressure range, the first pressure range being identical to the second pressure range.

6. The thermal chemical vapor deposition split-functionalizing process of claim 1, further comprising surface functionalizing the article.

7. The thermal chemical vapor deposition split-functionalizing process of claim 6, wherein the surface functionalizing is by exposing the article to trimethylsilane.

8. The thermal chemical vapor deposition split-functionalizing process of claim 1, wherein the functionalizing is to an interior portion of a tube.

9. The thermal chemical vapor deposition split-functionalizing process of claim 1, wherein the functionalizing of the article is to a surface previously applied to a substrate of the article.

10. The thermal chemical vapor deposition split-functionalizing process of claim 9, wherein the surface is a metal or metallic substrate or wherein the surface is a ceramic substrate.

11. The thermal chemical vapor deposition split-functionalizing process of claim 1, wherein the functionalizing of the article is to a substrate of the article.

12. The thermal chemical vapor deposition split-functionalizing process of claim 1, further comprising oxidizing the article within the enclosed chamber.

13. The thermal chemical vapor deposition split-functionalizing process of claim 1, further comprising exposing the article to dimethylsilane at conditions above the decomposition conditions for the dimethylsilane.

14. A thermal chemical vapor deposition split-functionalizing process, comprising:
positioning an article within an enclosed chamber;
exposing the article to dimethylsilane at conditions above the decomposition conditions for the dimethylsilane to produce a surface;
oxidizing the article within the enclosed chamber to produce an oxidized surface;
functionalizing within a first temperature range for a first period of time exposing the oxidized surface to trimethylsilane; and then
further functionalizing within a second temperature range for a second period of time;
wherein the first temperature range and the second temperature range are within a range of 400°C and 500°C.

15. A thermal chemical vapor deposition split-functionalized product, comprising:
a functionalization formed by functionalizing within a first temperature range for a first period of time; and
a further functionalization formed by further functionalizing within a second temperature range for a second period of time.
